# EUROPÄISCHE PATENTSCHRIFT

(11) **EP 3 445 890 B1**
(45) Veröffentlichungstag und Bekanntmachung des Hinweises auf die Patenterteilung: **29.07.2020**
(21) Anmeldenummer: 17721957.3
(22) Anmeldetag: 21.04.2017
(51) Int. Cl.: C23C 14/00, H01J 37/34, C23C 14/02, C23C 14/06, C23C 14/34, C23C 14/35

(54) **TICN MIT REDUZIERTEN WACHSTUMSDEFEKTEN MITTELS HIPIMS**
TICN HAVING REDUCED GROWTH DEFECTS BY MEANS OF HIPIMS
TICN À DÉFAUTS DE CROISSANCE RÉDUITS OBTENU PAR HIPIMS

(30) Priorität: 22.04.2016 US 201662326098 P
(43) Veröffentlichungstag der Anmeldung: 27.02.2019
(73) Patentinhaber: Oerlikon Surface Solutions AG, Pfäffikon, 8808 Pfäffikon (CH)
(72) Erfinder: KURAPOV, Denis, CH-8880 Walenstadt (CH); KRASSNITZER, Siegfried, 6800 Feldkirch (AT)
(74) Vertreter: Misselhorn, Hein-Martin
(86) Internationale Anmeldenummer: PCT/EP2017/000500
(87) Internationale Veröffentlichungsnummer: WO 2017/182124

(56) Entgegenhaltungen:
- WO-A1-2014/207154
- US-A1- 2015 037 710

## Beschreibung

Die vorliegende Erfindung bezieht sich auf eine Methode zur Beschichtung von Oberflächen, insbesondere Oberflächen von Werkstücken, Bauteilen oder Werkzeugen, mit einer TiCN-Beschichtung mit reduzierten Wachstumsdefekten.

### Stand der Technik

Bei der Beschichtung mittels reaktiven Sputter- oder HiPIMS-Prozessen wird oft ein metallisches Target als Zerstäubungsmaterialquelle verwendet und es kommt dabei zumindest ein Reaktivgas zusätzlich zum Arbeitsgas zum Einsatz. Im Rahmen der vorliegenden Erfindung werden die Begriffe "zerstäuben" und "sputtern" als identisch verstanden. Als Target wird im Rahmen der vorliegenden Erfindung derjenige Bestandteil einer Sputterquelle bezeichnet, von welchem während des Verfahrens Material abgetragen wird.

Für die Abscheidung von Schichten bei reaktiven Sputterprozessen oder auch bei kathodischer Lichtbogenverdampfung, auch Arcen genannt, werden üblicherweise zwei Reaktivgase benötigt. Dem Stand der Technik entsprechend sind dies in der Regel Stickstoff, sowie ein kohlenstoffhaltiges Gas, welches meistens Acetylen (C₂H₂) ist. Während die Lichtbogenverdampfung als relativ "robuster" Prozess angesehen werden kann, nimmt insbesondere bei Sputter- oder HiPIMS-Prozessen die Prozessgasregelung eine entscheidende Rolle für die Prozessstabilität ein.

Krassnitzer offenbart beispielsweise in WO2014207154 eine Methode zur Abscheidung von TiCN Schichten mittels HiPIMS, wobei Ti-Targets in einer reaktiven N₂- und C₂H₂-haltigen Atmosphäre gesputtert werden, um TiCN Schichten auf Substratoberflächen aufzubringen. Der HiPIMS Prozess wird unter Verwendung von Leistungspulsen und/oder Leistungspulssequenzen mit einem auf die Target-Fläche bezogenen Energieinhalt von mindestens 0.2 joule/cm² pro Leistungspuls bzw. pro Leistungspulssequenz durchgeführt. Es wird vorgeschlagen, die Konzentration der Reaktivgase in der Beschichtungskammer durch die Steuerung oder Regelung der Reaktivgasflüsse zu kontrollieren, und verschiedene Eigenschaften wie zum Beispiel Farbeindruck durch die Konzentration der Reaktivgase in der Beschichtungskammer zu kontrollieren.

Es ist bekannt, dass während des Sputter- oder HiPIMS-Prozesses die beiden Reaktivgase mit dem verdampften Targetmaterial reagieren und eine MetallKeramik-Schicht auf dem Substrat bilden. Um eine Verdichtung der Schicht zu erreichen, wird üblicherweise eine negative Substratvorspannung, Biasspannung, am Substrat angelegt, um die positiv geladenen Ionen auf das Substrat zu beschleunigen.

Es ist ebenfalls bekannt, dass die genaue Kenntnis und Steuerung eines Sputter- bzw. HiPIMS-Prozesses von enormer Wichtigkeit ist, um optimale Schichteigenschaften reproduzierbar einstellen zu können. Hierbei kann die Wahl eines optimalen Arbeitspunktes als besonders kritisch angesehen werden, da eine bereits geringfügige Abweichung von diesem Arbeitspunkt während des Prozesses zu Schwankungen in der Schichtqualität, veränderten Farbeigenschaften, bis hin zur Prozessinstabilität und schlussendlich zu einem Prozessabbruch führen können. Als Arbeitspunkt wird hierbei ein bestimmtes Verhältnis von Arbeitsgas zu dem einen oder mehreren Reaktivgasen verstanden. Um einen gewählten Arbeitspunkt während des Prozesses konstant beizubehalten, wird in der Regel eine Gasfluss- oder Partialdruckregelung verwendet. Dies bedeutet im Falle von nur einem Reaktivgas, also beispielsweise bei der Abscheidung von TiN, einen Ar-Partialdruck von 0.40 Pa und einen N₂-Partialdruck von 0.03 Pa, womit ein Gesamtdruck von 0.43 Pa eingestellt wird. In einem HiPIMS-Prozess kann der Arbeitspunkt stark von den gewählten Prozessbedingungen, wie z.B. der gemittelten Pulsleistung, Pₐᵥ, oder der Pulsdauer, tₚᵤₗₛ, aber auch vom Zustand und Alter des verwendeten Targets oder der Pumpleistung abhängen. Der eingestellte Arbeitspunkt, respektive der N₂-Partialdruck bzw. der sich ergebende Gesamtdruck, wird in der Regel durch Anpassung des N₂-Flusses durchgeführt.

Werden nun jedoch zwei oder mehrere Reaktivgase, wie etwa N₂ und C₂H₂, gleichzeitig verwendet, ist dieses Konzept nicht mehr anwendbar, da man nur ein Reaktivgas druckgeregelt kontrollieren kann und das andere Reaktivgas üblicherweise mit einer fixen Flussmenge in die Kammer eingelassen wird.

Es ist aus oben genannten Gründen daher ersichtlich, dass geringfügige Änderungen der Prozesseinflussgrössen eine Abweichung vom gewünschten Arbeitspunkt nach sich ziehen, was sich wiederum nachteilig auf die erwünschte Schichtqualität auswirken kann.

Die oben genannten Probleme nehmen insbesondere bei der reaktiven Abscheidung von TiCN, wobei die beiden Elemente Kohlenstoff und Stickstoff aus der Gasphase bezogen werden und mit dem vom Titantarget gesputterten Titan zu TiCN reagieren, eine entscheidende Rolle ein. Bereits geringfügige Abweichungen des optimalen Arbeitspunktes können erhebliche Abweichungen der Schichteigenschaften bewirken.

Ein anderer kritischer Aspekt bei reaktiven Sputter- oder HiPIMS-Prozessen ist die Reaktion eines oder mehrerer Reaktivgase mit der Targetoberfläche, wodurch sich in der Regel keramische Reaktionsprodukte bilden. Generell wird dieser Vorgang als Targetvergiftung oder Targetpoisioning bezeichnet und kann erhebliche Auswirkungen auf die Sputtercharakteristik, respektive den Arbeitspunkt eines Prozesses haben. Wenn sich bei der Targetvergiftung schlecht leitfähige oder sogar isolierende Verbindungen an der Targetoberfläche bilden, kann dies zu einem drastischen Anstieg der Entladungsspannung führen und im schlimmsten Fall einen Zusammenbruch des Sputterplasmas bewirken, wenn die gesamte Targetfläche "zugewachsen" ist.

In EP2565291A1 wird vorgeschlagen, dieses Phänomen der Targetvergiftung bei der Verwendung von reaktiven Sputterprozessen mit unterschiedlichen Targetmaterialien dadurch zu vermeiden, indem man an der jeweiligen Sputterquelle einen Gasflussregler anbringt, welcher den Reaktivgasfluss danach einstellt, wie hoch der Vergiftungsgrad des jeweiligen Sputtertargets ist, was wiederum durch eine Messung der Quellenspannung erfolgt und nach einem vordefinierten Sollwert somit die Regelung des Reaktivgasflusses ermöglicht. Dieses Verfahren ist allerdings relativ aufwendig in der Umsetzung und erfordert detaillierte Kenntnis der Vorgänge am Target in Verbindung mit den Reaktivgasen. Darüber hinaus wird keine Möglichkeit gegeben, einen beliebigen Arbeitspunkt, hinsichtlich dem Verhältnis Arbeitsgas zu Reaktivgas, zu wählen.

Es ist somit von vorrangiger Bedeutung, ein Verfahren zu haben, welches in Abhängigkeit der gewünschten Schichteigenschaften erlaubt auch den dafür notwendigen Arbeitspunkt beliebig wählen zu können und dabei stabil zu betreiben ist. Die gegenwärtige Erfindung ermöglicht genau diesen Schritt.

Um eine Verdichtung der Schicht zu erreichen, wird üblicherweise eine negative Substratvorspannung, Biasspannung, am Substrat angelegt, um die positiv geladenen Ionen auf das Substrat zu beschleunigen. Bei der Abscheidung von Schichten in einem reaktiven Sputter- oder HIPIMS-Prozess sollte bei der Verwendung von direct current (DC) Biasspannung die verwendete Spannung höher sein als das Plasmapotential. Üblicherweise wird eine DC Biasspannung höher als -30 V, also beispielsweise -40 V, angelegt, um eine Beschleunigung der Ionen auf das Substratmaterial zu erreichen. Durch eine Erhöhung der DC Biasspannung, von beispielsweise -40V auf -80V, wird eine Erhöhung der lonenenergie erreicht, was sich in einer erhöhten Verdichtung der Schicht und üblicherweise auch in der Erhöhung der Eigenspannungen der Schicht ausdrückt. Oftmals kann durch die Erhöhung der Eigenspannung auch eine Erhöhung der Schichthärte beobachtet werden.

Jedoch, obwohl eine hohe Härte zwar in vielen Anwendungen gewünscht ist, kann es durch die zeitgleiche Erhöhung der Eigenspannungen zu erheblichen Schwierigkeiten kommen, die gewünschte Schichtdicke von einigen Mikrometern an der gewünschten Stelle des Bauteils, oder Werkzeuges, zu erzielen. Zu hohe Eigenspannungen in der, Schicht führen zu teilweisen oder sogar grossflächigen Abplatzungen der Schicht.

In herkömmlichen Sputter- oder HiPIMS-Prozessen beinhaltet das Schichtwachstum den Einbau von Wachstumsdefekten.

Bei der Herstellung von TiCN mittels herkömmlicher Sputter- oder HiPIMS-Prozesse erfolgt beim Schichtwachstum der Einbau von Wachstumsdefekten, welche beispielsweise von metallischen, nicht vollständig zerstäubten, Partikeln des Targets oder aber auch von Verunreinigungen in der Anlage kommen können. Ausserdem ist es schwierig, zu unterscheiden, wo genau die Reaktion des zerstäubten Targetmaterials mit dem/den Reaktivgasen erfolgt, was bedeutet, dass bereits durchreagiertes TiCN an der Targetoberfläche eines Titantargets vorhanden sein kann, welches dann als "Mikropartikel" zerstäubt wird und als Wachstumsdefekt in die am Substrat aufwachsende Schicht eingebaut werden kann. Dieser Vorgang des Reagierens von Reaktivgasen mit dem Targetmaterial an der Targetoberfläche wird normalerweise als "Vergiftung" bezeichnet und ist stark von den Prozessparametern, und hier insbesondere von der Reaktivgasflussregelung, abhängig. Man sagt, dass ein Target komplett vergiftet ist, wenn die Targetoberfläche total durch ein oder mehrere Reaktionsprodukte abgedeckt ist.

Darüber hinaus ist eine hohe Oberflächengüte der Schicht am Substrat oftmals schichtdickenabhängig, da bereits kleinere Wachstumsdefekte während des Schichtwachstums zu einer beträchtlichen Erhöhung der Rauigkeit des beschichteten Bauteils oder Werkzeuges führen. Dies bedeutet, dass dickere Schichten tendenziell eine höhere Rauigkeit aufweisen, als dies bei gleichen Abscheidebedingungen bei einer dünneren Schicht der Fall wäre.

### Aufgabe der vorliegenden Erfindung

Der vorliegenden Erfindung liegt die Aufgabe zugrunde, eine Methode bereitzustellen, welche die Herstellung von TiCN Schichten mit geringeren Wachstumsdefekten ermöglicht, jedoch aber gleichzeitig möglichst zu keinem Schichthärteverlust oder keiner Zunahme der Schichteigenspannungen führt.

Wünschenswert soll die erfinderische Methode eine hohe Prozessinstabilität einbeziehen.

### Lösung gemäss der vorliegenden Erfindung

Die Aufgabe der vorliegenden Erfindung wird durch die Bereitstellung einer Methode nach Anspruch 1 gelöst.

Erfindungsgemäss wird eine Beschichtung mit mindestens einer TiCN-Schicht auf einer Oberfläche eines zu beschichtenden Substrat mittels HiPIMS aufgebracht, wobei zur Abscheidung der mindestens einen TiCN-Schicht mindestens ein Ti-haltiges Target, besipielweise ein Ti-Target, als Ti-Quelle für die Erzeugung der TiCN-Schicht verwendet wird, welches in einer reaktiven Atmosphäre mittels eines HiPIMS-Verfahrens in einer Beschichtungskammer gesputtert wird, wobei die reaktive Atmosphäre mindestens ein Edelgas, vorzugweise Argon, und mindestens Stickstoffgas als Reaktivgas umfasst, und wobei zur Reduzierung von Wachstumsdefekten während der Abscheidung der zumindest einen TiCN-Schicht
- die reaktive Atmosphäre zusätzlich als zweites Reaktivgas ein kohlenstoffhaltiges Gas, vorzugsweise CH₄, umfasst, welches als Kohlenstoffquelle für die Erzeugung der TiCN-Schicht verwendet wird, wobei während der Abscheidung der TiCN-Schicht eine bipolare Biasspannung auf das zu beschichtende Substrat angelegt wird,
   oder
- als Kohlenstoffquelle für die Erzeugung der TiCN-Schicht mindestens ein kohlenstoffhaltiges Target, beispielsweise ein Graphit-Target, verwendet wird, welches in der Beschichtungskammer mit der reaktiven Atmosphäre mit lediglich Stickstoffgas als Reaktivgas mittels eines HiPIMS-Verfahrens gesputtert wird, wobei die Ti-haltigen Targets vorzugsweise mit Hilfe eines ersten Leistungsversorgungsgeräts oder einer ersten Leistungsversorgungseinheit und die Graphit-haltigen Targets vorzugsweise mit Hilfe eines zweiten Leistungsversorgungsgeräts oder einer zweiten Leistungsversorgungseinheit mit gepulster Leistung betrieben werden.

### Beschreibung der Erfindung

Die Erfinder haben gefunden, dass es überraschenderweise möglich ist, Hartstoffschichten aus TiCN mit einer sehr hohen Härte bei gleichzeitig einer sehr glatten Schichtoberfläche und zudem vergleichsweise niedrigen Eigenspannungen mittels reaktiver HiPIMS-Prozesse zu produzieren, wenn beim HiPIMS-Prozess eine bipolare Biasspannung verwendet wird. Die Erfinder haben ebenfalls gefunden, dass es überraschenderweise möglich ist, Hartstoffschichten aus TiCN mit einer sehr hohen Härte bei gleichzeitig einer sehr glatten Schichtoberfläche mittels reaktiver HiPIMS-Prozesse zu produzieren, wenn beim HiPIMS-Prozess nur Stickstoff als Reaktivgas verwendet wird und der Kohlenstoff für die Herstellung von TiCN aus einem kohlenstoffhaltigen Target bereitgestellt wird.

Damit wird es möglich, dickere Schichten aufwachsen zu lassen und die oben genannten Probleme zu überwinden, um z. B. im Anwendungsbereich eine ausreichend dicke Schicht mit hoher Oberflächengüte, also niedriger Rauigkeit, zu erzeugen.

Zur Abscheidung der erfindungsgemässen TiCN Schichten wurde ein HiPIMS Verfahren verwendet, welches sehr hohe Leistungsimpulse oder Leistungspulssequenzen auf die Targetoberfläche eines oder mehrerer Titan Targets aufbringt. Während der Pulsdauer, tₚᵤₗₛ, eines Leistungspulses oder während einer Sequenz-Dauer, t_{pulssequenz}, einer Leistungspulssequenz wird mittels positiv geladener Ar-Ionen Energie in die Targetoberfläche eingebracht, wodurch Targetmaterial herausgeschlagen bzw. zerstäubt wird. Im Falle eines HIPIMS Verfahrens ist der Anteil des ionisierten Zerstäubungsmaterials erheblich höher als im herkömmlichen Sputterverfahren. Der Energiegehalt beim HIPIMS Prozess kann sehr einfach über die Einstellung einer entsprechend hohen Pulsleistung, P, und/oder einer entsprechend sehr grossen Pulslänge bzw. Pulsdauer, tₚᵤₗₛ, erreicht werden.

Standard HiPIMS Konfigurationen und Beschichtungsparameter sind aus dem Stand der Technik bekannt.

Im Rahmen der vorliegenden Erfindung wurden insbesondere solche HiPIMS Verfahren verwendet, die beispielweise von Krassnitzer in WO2012143091A1 beschrieben sind.

Die Erfindung wird im Folgenden im Detail und anhand von Figuren bzw. Tabellen beispielhaft ergänzt.
Fig. 1: Tabelle mit einer Übersicht der Eigenschaften von beispielhaft abgeschiedenen TiCN Schichten, welche unter Verwendung einer bipolaren Biasspannung gemäss dem Beispiel 1 (siehe C, D, E) abgeschieden wurden, im Vergleich mit TiCN Schichten, welche unter Verwendung einer DC Spannung gemäss dem Stand der Technik abgeschieden wurden (siehe A, B).

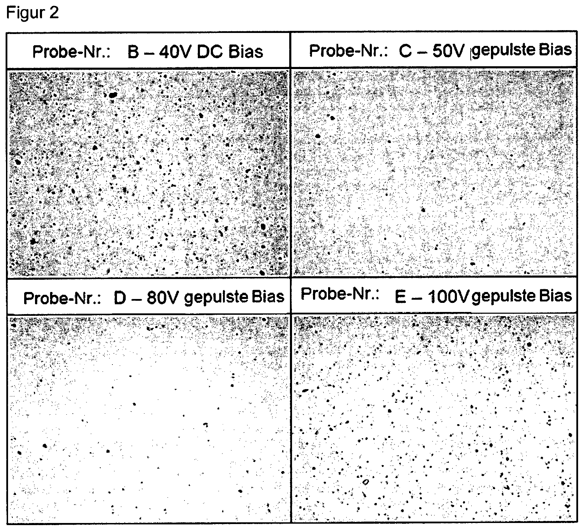

Fig. 2: Lichtmikroskopische Aufnahmen der Schichtoberfläche von TiCN Schichten gemäss dem Beispiel 1 mit unterschiedlichen Biasspannungen.
Fig. 3: Tabelle mit einer Übersicht der Eigenschaften von beispielhaft abgeschiedenen TiCN Schichten, welche unter Verwendung von Ti- und Graphit-Targets gemäss dem Beispiel 2 (siehe A, B, C, D, E) abgeschieden wurden, im Vergleich mit TiCN Schichten, welche unter Verwendung von nur Ti-Targets und einer DC Spannung gemäss dem Stand der Technik abgeschieden wurden (siehe REF).
Fig. 4: Lichtmikroskopische Aufnahmen der Schichtoberfläche von TiCN Schichten gemäss dem Beispiel 2 mit unterschiedlichen Target- bzw. Reaktivgasanordnungen.

### Beispiel 1 (gemäss einer 1. bevorzugten Ausführungsform):

Alle beispielhaft gezeigten TiCN-Schichten gemäss diesem ersten Beispiel wurden mit einer dünnen TiN Schicht als Haftschicht hergestellt. Zuerst wurde die TiN-Haftschicht auf die zu beschichtende Oberfläche abgeschieden, wobei folgende Parameter verwendet wurden: eine Pulsleistung, Pₚᵤₗₛ, von 60 kW, eine mittlere Leistung am Target von Pₐᵥ, von 9.0 kW bei einer tₚᵤₗₛ von 25 ms, bei einem Gesamtdruck, p_{ges}, von 0.81 Pa, mit einem N₂-Partialdruck von 0.01 Pa, einem Ar-Partialdruck von 0.4 Pa und einer konstanten DC-Biasspannung von -80 V bei einer Beschichtungstemperatur von 450 °C.

Die TiCN-Schichten wurden direkt anschliessend mit gleicher Pₚᵤₗₛ, gleicher Pₐᵥ, gleichem N₂-Partialdruck und Ar-Partialdruck, jedoch einem zusätzlich konstanten CH₄-Fluss von 50 sccm sowie einer kürzeren tₚᵤₗₛ von 1 ms aufgebracht.

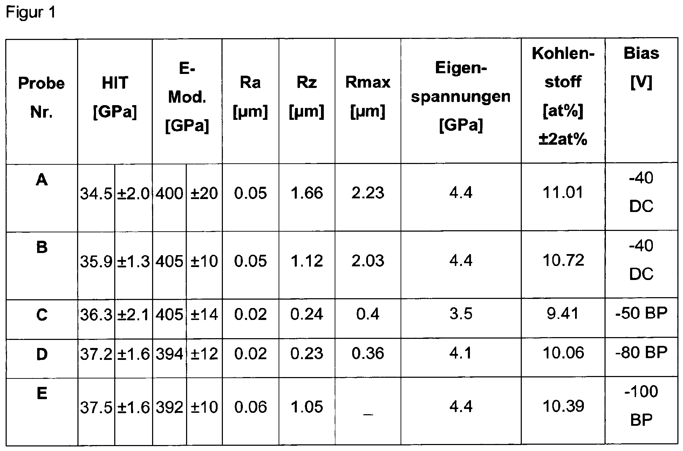

Für die Vergleichsbeispiele A und B in der Tabelle in der Figur 1 wurde eine DC Biasspannung sowohl bei der Abscheidung der TiN-Haftschicht als auch bei der Abscheidung der TiCN-Schicht angelegt.

Für die erfinderischen Beispiele C, D und E in der Tabelle 1 der Figur 1 wurde die Biasspannung erfindungsgemäss nach der Abscheidung der TiN-Haftschicht auf bipolaren gepulsten Betrieb verändert für die Abscheidung der erfinderischen TiCN-Schichten.

Alle Schichten hatten eine Schichtdicke von ca. 4.0 µm und wurden anschliessend charakterisiert, was in der Zusammenfassung der Schichteigenschaften in Tabelle 1 ersichtlich ist. Die Sample- bzw. Probennummern A und B wurden unter identischen Bedingungen, jedoch in unterschiedlichen Chargen, mit konstanter DC-Biasspannung von -40 V abgeschieden. Die Probennummer C, D und E wurden mit einer bipolar gepulsten Biasspannung von -50 V, -80 V und -100 V, respektive, abgeschieden. Das zeitliche Verhältnis t_{neg}:tₚₒₛ der negativen Biasspannung zur positiven Biasspannung wurde mit 50:25 ms für die Proben C, D und E konstant gehalten.
Überraschenderweise wurde bei der erfindungsgemässen Verwendung von gepulster Biasspannung anstatt DC-Biasspannung eine deutliche Reduktion der Rauheitswerte Ra, Rz und Rmax festgestellt bei vergleichbarer und sogar höherer Biasspannung beobachtet. In Figur 1 sind Lichtmikroskopbilder der beschichteten Probenoberflächen gezeigt, wo Vergleichsprobe B (konst. -40 V - DC) mit den Proben C, D und E mittels verglichen wird. Der optische Eindruck der "schwarzen" Punkte wird durch Wachstumsdefekte erzeugt, welche die ansonsten sehr glatte Oberflächenstruktur im Auflicht stören. Es kann deutlich bei den Proben C bis E im Vergleich zu Probe B eine geringere Dichte von schwarzen Punkten gesehen werden, was mit den gemessenen Rauheitswerten gut übereinstimmt. Interessanterweise ist jedoch der gemessene Kohlenstoffgehalt der Schichten, im Rahmen der angegebenen Messungenauigkeit, unabhängig von der verwendeten Methode die Biasspannung aufzubringen und in etwa konstant bei 10±2 at%.

Überraschenderweise wurden jedoch bei den TiCN-Schcihten mit gepulster Biasspannung deutlich niedrigere Eigenspannungswerte gemessen als bei den Vergleichsproben mit DC-Biasspannung. Wie aus der Tabelle 1 ersichtlich, wurde erst bei -100 V gepulster Biasspannung das gleiche Eigenspannungsniveau von -4.4 GPa erreicht, das bereits bei der Verwendung von -40 V DC-Biasspannung auftritt. Weiters konnte eine moderate Zunahme der Härte mit gepulster Biasspannung beobachtet werden, was tendenziell für die Anwendung erwünscht ist.

Es wird eine Biasspannung im Bereich von -20 V bis -200 V verwendet.

Das zeitliche Verhältnis t_{neg}:tₚₒₛ der negativen Biasspannung zur positiven Biasspannung liegt in einem Bereich von 10:1 bis 1:5, bevorzugt 5:1 bis 1:2, besonders bevorzugt von 2:1 bis 1:1.

Die Biasspannungshöhe kann so eingestellt werden, dass sie asymmetrisch oder symmetrisch ist. Bei asymmetrischem Betrieb kann man Ionen- und Elektronenstrom unabhängig voneinander einstellen.

Vorzugsweise wird als kohlenstoffhaltiges Gas Acetylen (C₂H₂) oder Methan (CH₄) verwendet.

Gemäß einer weiteren Ausführungsform der Erfindung können statt metallischen Titan Targets keramische TiC Targets oder Targets aus Ti und TiC bei der Abscheidung von TiCN Schichten verwendet werden.

### Beispiel 2 (gemäss einer 2. bevorzugten Ausführungsform):

Alle beispielhaft gezeigten TiCN-Schichten gemäss diesem zweiten Beispiel wurden mit einer dünnen TiN Schicht als Haftschicht hergestellt. Zuerst wurde die TiN-Haftschicht auf die zu beschichtende Oberfläche abgeschieden, wobei folgende Parameter verwendet wurden: eine Pulsleistung, Pₚᵤₗₛ, von 60 kW, eine mittlere Leistung am Target von Pₐᵥ, von 9.0 kW bei einer tₚᵤₗₛ von 25 ms, bei einem Gesamtdruck, p_{ges}, von 0.81 Pa, mit einem N₂-Partialdruck von 0.01 Pa, einem Ar-Partialdruck von 0.4 Pa und einer konstanten DC-Biasspannung von -80 V bei einer Beschichtungstemperatur von 450 °C.

Hierbei wurden drei Titantargets in der oben angegebenen Weise betrieben.

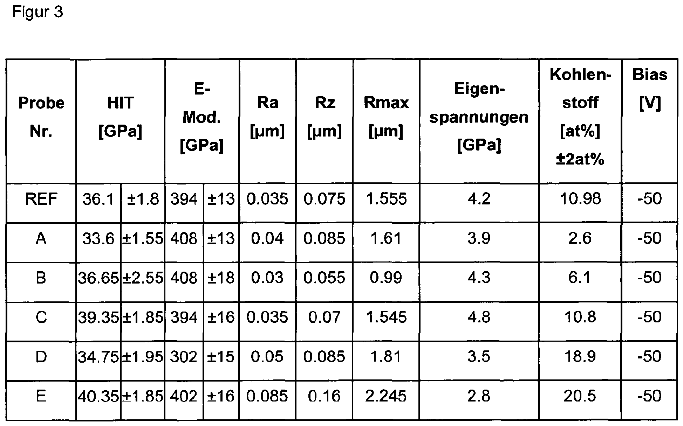

Die TiCN-Schichten (A, B, C, D, E in der Tabelle in Fig. 3) wurden erfindungsgemäss direkt anschliessend abgeschieden, wobei die drei Titantargets mit gleichen Einstellungen wie zuvor betrieben wurden, jedoch zusätzlich drei Kohlenstofftargets hinzugeschaltet wurden.

Die drei Kohlenstofftargets wurden in unterschiedlichen beispielhaften Prozessen, mit jeweils Pₚᵤₗₛ von 60 kW, konstanter Biasspannung von -50 V, jedoch unterschiedlichen tₚᵤₗₛ von 0.05, 0.1, 0.2, bzw. 0.3 ms, und sich daraus ergebenden Pₐᵥ von 0.4, 0.9, 1.8, bzw. 2.8 kW abgeschieden. Die zugehörigen Proben sind in der Folge als A, B, C, bzw. D angeführt und die Eigenschaften in der Figur 3 angegeben.

Als Referenzprobe (REF) wurde eine herkömmlich abgeschiedene TiCN-Schicht, wiederum mit der gleichen TiN-Haftschicht wie oben beschrieben, hergestellt, wobei jedoch für die TiCN-Schicht wurden ausschliesslich Titantargets vewendet und Ar als Prozessgas mit einem Partialdruck von 0.40 Pa, N₂ als erstes Reaktivgas mit einem Partialdruck von 0.01 Pa, sowie zusätzlich als zweites Reaktivgas 50 sccm CH₄ verwendet, was einen Gesamtdruck p_{ges} von 0.47 Pa entspricht. Eine DC-Biasspannung wurde sowohl für die Abscheidung der TiN-Haftschicht als auch für die Abscheidung der TiCN Schicht verwendet. Diese Einstellungen für die Referenzprobe entsprechen dem Stand der Technik wie oben einführend erwähnt und dienen für Vergleichszwecke hinsichtlich Schichteigenschaften und Prozessstabilität.

Als weitere Vergleichsprobe E wurde ein Prozess mit oben beschriebener TiN-Haftschicht, jedoch unter Verwendung von zwei Prozessgasen und zwei Targetarten für die TiCN-Schicht herangezogen. Hierbei wurden die Parameter für die drei Titantargets wie oben beschrieben konstant gehalten, und für die drei Kohlenstofftargets wurden vergleichbare Einstellungen wie für Probe C, mit jeweils Pₚᵤₗₛ von 60 kW, konstanter Biasspannung von -50 V, tₚᵤₗₛ von 0.2 ms, und sich daraus ergebenden Pₐᵥ von 1.8 kW, einem Ar-Partialdruck von 0.4 Pa, einem N₂-Partialdruck von 0.03 sowie einem fixen CH₄-Fluss von 10 sccm abgeschieden.

Alle beispielhaft gezeigten Schichten hatten eine Schichtdicke von ca. 4.0 µm und wurden anschliessend charakterisiert, was in der Zusammenfassung der Schichteigenschaften in der Tabelle in Figur 1 ersichtlich ist.

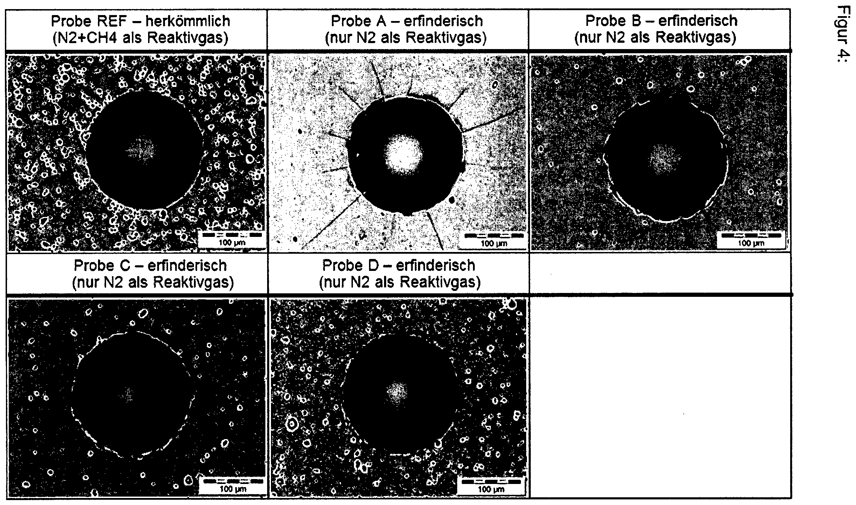

In Figur 4 sind Lichtmikroskopbilder der beschichteten Probenoberflächen gezeigt, wo Vergleichsprobe REF mit den Proben A, B, C und D verglichen wird. Der optische Eindruck der "schwarzen" Punkte wird durch Wachstumsdefekte erzeugt, welche die ansonsten sehr glatte Oberflächenstruktur im Auflicht stören. Überraschenderweise weisen die Proben A bis D im Vergleich zu Probe REF eine geringere Dichte von schwarzen Punkten auf, was mit den gemessenen Rauheitswerten gut übereinstimmt. Der Kohlenstoffanteil steigt mit steigender Leistung am Target.

Interessanterweise konnte jedoch festgestellt werden, dass beim Vergleich der Proben REF und C zu sehen ist, dass diese beiden in etwa den gleichen Kohlenstoffgehalt haben, wobei eine deutlich höhere Schichthärte für die erfindungsgemäss abgeschiedene Probe C gemessen wurde. Dies bedeutet, dass die Venwendung von zwei Targetmaterialen, wobei eines Titan und das zweite in diesem Beispiel Kohlenstoff war, eine positive Auswirkung auf die Schichteigenschaften hat und darüber hinaus einen stabilen Prozess erlaubt.

Die Vergleichsprobe E, wobei die beiden unterschiedlichen Targetmaterialien Titan und Kohlenstoff, sowie N₂ und CH₄ als Reaktivgase verwendet wurden, weist eine erheblich höhere Oberflächenrauheit auf, was allerdings im Vergleich zu einer linearen Korrelation der Kohlenstoffgehalte bzw. Rauigkeiten der erfindungsgemäss abgeschiedenen Proben A, B, C und D mit dem hohen Kohlenstoffanteil in der Probe E zu tun haben dürfte.

Es ist im Rahmen der Erfindung denkbar, dass man eine Feinabstimmung des Kohlenstoffgehaltes durch den Einsatz von kohlenstoffhaltigen Targets aus einem Verbundmaterial erzielen kann. In diesem Zusammenhang ist beispielweise ein Verbund gemeint, der etwa ein oder mehrere Metallen und ein oder mehrere Karbide umfasst, beispielweise ein Target aus TiC oder Ti+TiC.

Ebenso ist es denkbar, dass andere Metalle, wie etwa Cr, Zr, Ta, Nb, etc für das erfindungsgemässe Verfahren verwendet werden.

Vorzugsweise wird ein Gesamtdruck im Bereich von 10⁻⁴ mbar (0.02 Pa) bis 10⁻² mbar (2 Pa), eine Leistungsdichte im Bereich von 0.1 kW/cm² bis 3.0 kW/cm ² und/oder mittlere Leistung Pₐᵥ im Bereich von 0.05 bis 10 kW verwendet. Das Partialdruckverhältnis Ar zu N₂ kann innerhalb eines Bereichs von 0.01 bis 0.95 variieren.

Vorzugsweise wird als kohlenstoffhaltiges Gas Acetylen (C₂H₂) oder Methan (CH₄) verwendet.

Gemäß einer weiteren Ausführungsform der Erfindung können statt metallischen Titan Targets keramische TiC Targets oder Targets aus Ti und TiC bei der Abscheidung von TiCN Schichten verwendet werden.

Konkret offenbart die vorliegende Erfindung eine Methode zum Aufbringen einer Beschichtung mit mindestens einer TiCN-Schicht auf einer Oberfläche eines zu beschichtenden Substrats mittels HiPIMS, wobei zur Abscheidung der mindestens einen TiCN-Schicht mindestens ein Ti-haltiges Target als Ti-Quelle für die Erzeugung der TiCN-Schicht verwendet wird, welches in einer reaktiven Atmosphäre mittels eines HiPIMS-Verfahrens in einer Beschichtungskammer gesputtert wird, wobei die reaktive Atmosphäre mindestens ein Edelgas, vorzugweise Argon, und mindestens Stickstoffgas als Reaktivgas umfasst, wobei zur Reduzierung von Wachstumsdefekten während der Abscheidung der zumindest einen TiCN-Schicht:
- die reaktive Atmosphäre zusätzlich als zweites Reaktivgas ein kohlenstoffhaltiges Gas umfasst, welches als Kohlenstoffquelle für die Erzeugung der TiCN-Schicht verwendet wird, wobei während der Abscheidung der TiCN-Schicht eine bipolare Biasspannung auf das zu beschichtende Substrat angelegt wird,
   oder
- als Kohlenstoffquelle für die Erzeugung der TiCN-Schicht mindestens ein kohlenstoffhaltiges Target verwendet wird, welches in der Beschichtungskammer mit der reaktiven Atmosphäre mit lediglich Stickstoffgas als Reaktivgas mittels eines HiPIMS-Verfahrens gesputtert wird.

Vorzugsweise kann die Methode so durchgeführt werden, dass wenn ein kohlenstoffhaltiges Gas als Kohlenstoffquelle verwendet wird, das kohlenstoffhaltige Gas CH₄ umfasst, oder aus CH₄ besteht, oder C₂H₂ umfasst, oder aus C₂H₂ besteht.

Vorzugsweise kann die Methode so durchgeführt werden, dass wenn ein kohlenstoffhaltiges Target als Kohlenstoffquelle verwendet wird, ein oder mehrere Ti-haltige Targets mit Hilfe eines ersten Leistungsversorgungsgeräts oder einer ersten Leistungsversorgungseinheit und ein oder mehrere kohlenstoffhaltige Targets mit Hilfe eines zweiten Leistungsversorgungsgeräts oder einer zweiten Leistungsversorgungseinheit mit gepulster Leistung betrieben werden.

Nach einer bevorzugten Variante der oben beschriebenen Methoden sind ein oder mehrere Ti-haltige Targets metallische Targets, welche aus Ti bestehen.

Nach einer weiteren bevorzugten Variante der oben beschriebenen Methoden sind ein oder mehrere Ti-haltige Targets keramische Targets, welche aus TiC bestehen.

Nach einer weiteren bevorzugten Variante der oben beschriebenen Methode, bei dem mindestens ein kohlenstoffhaltiges Target verwendet wird, bestehen ein oder mehrere kohlenstoffhaltige Targets aus Graphit.

Nach einer weiteren bevorzugten Variante der oben beschriebenen Methode, bei dem mindestens ein kohlenstoffhaltiges Target verwendet wird, bestehen ein oder mehrere kohlenstoffhaltige Targets aus einem Verbundmaterial, wobei das Verbundmaterial beispielweise ein Metall oder mehrere Metalle und ein Karbid oder mehrere Karbide umfasst.

## Patentansprüche

1. Methode zum Aufbringen einer Beschichtung mit mindestens einer TiCN- Schicht auf einer Oberfläche eines zu beschichtenden Substrats mittels HiPIMS, wobei zur Abscheidung der mindestens einen TiCN-Schicht mindestens ein Ti-haltiges Target als Ti-Quelle für die Erzeugung der TiCN-Schicht verwendet wird, welches in einer reaktiven Atmosphäre mittels eines HiPIMS-Verfahrens in einer Beschichtungskammer gesputtert wird, wobei die reaktive Atmosphäre mindestens ein Edelgas und mindestens Stickstoffgas als Reaktivgas umfasst, **dadurch gekennzeichnet, dass** zur Reduzierung von Wachstumsdefekten während der Abscheidung der zumindest einen TiCN-Schicht:
- die reaktive Atmosphäre zusätzlich als zweites Reaktivgas ein kohlenstoffhaltiges Gas umfasst, welches als Kohlenstoffquelle für die Erzeugung der TiCN-Schicht verwendet wird, wobei während der Abscheidung der TiCN-Schicht eine bipolare Biasspannung auf das zu beschichtende Substrat angelegt wird, wobei die Biasspannung in einem Bereich von -20 V bis -200 V verwendet wird, wobei die Biasspannungshöhe so eingestellt wird, dass sie asymmetrisch oder symmetrisch ist, und wobei das zeitliche Verhältnis t_{neg}:tₚₒₛ der negativen Biasspannung zur positiven Biasspannung in einem Bereich von 10:1 bis 1:5 liegt,
oder
- als Kohlenstoffquelle für die Erzeugung der TiCN-Schicht mindestens ein kohlenstoffhaltiges Target verwendet wird, welches in der Beschichtungskammer mit der reaktiven Atmosphäre mit lediglich Stickstoffgas als Reaktivgas mittels eines HiPIMS-Verfahrens gesputtert wird.

2. Methode nach Anspruch 1, bei der als Kohlenstoffquelle ein kohlenstoffhaltiges Gas verwendet wird, wobei das kohlenstoffhaltige Gas CH₄ umfasst, oder aus CH₄ besteht.

3. Methode nach Anspruch 1, bei der als Kohlenstoffquelle ein kohlenstoffhaltiges Gas verwendet wird, wobei das kohlenstoffhaltige Gas C₂H₂ umfasst, oder aus C₂H₂ besteht.

4. Methode nach Anspruch 1, bei der als Kohlenstoffquelle mindestens ein kohlenstoffhaltiges Target verwendet wird, wobei eine oder mehrere Ti-haltige Targets mithilfe eines ersten Leistungsversorgungsgeräts oder einer ersten Leistungsversorgungseinheit und eine oder mehrere kohlenstoffhaltige Targets mithilfe eines zweiten Leistungsversorgungsgeräts oder einer zweiten Leistungsversorgungseinheit mit gepulster Leistung betrieben werden.

5. Methode nach Anspruch 4, wobei mindestens ein Ti-haltiges Target ein metallisches Target ist, welches aus Ti besteht.

6. Methode nach Anspruch 4, wobei mindestens ein Ti-haltiges Target ein keramisches Target ist, welches aus TiC besteht.

7. Methode nach einem der vorangehenden Ansprüche 4 bis 6, bei der mindestens ein kohlenstoffhaltiges Target aus Graphit besteht.

8. Methode nach einem der vorangehenden Ansprüche 4 bis 6, bei der das mindestens eine kohlenstoffhaltige Target aus einem Verbundmaterial besteht.

9. Methode nach Anspruch 8, wobei das Target aus einem Verbundmaterial, welches mindestens ein Metall und ein Karbid umfasst, besteht.

## Claims

1. A method for applying a coating with at least one TiCN layer to a surface of a substrate to be coated by means of HiPIMS, wherein, for depositing the at least one TiCN layer, at least one Ti-containing target is used as a Ti source for producing the TiCN layer, which target is sputtered in a reactive atmosphere by means of a HiPIMS process in a coating chamber, wherein the reactive atmosphere comprises at least one noble gas and at least nitrogen gas as a reactive gas, **characterized in that**, in order to reduce growth defects during the deposition of the at least one TiCN layer:
- the reactive atmosphere additionally comprises, as a second reactive gas, a carbon-containing gas, which is used as a carbon source for producing the TiCN layer wherein, during the deposition of the TiCN layer, a bipolar bias voltage is applied to the substrate to be coated, wherein the bias voltage in a range from -20 V to -200 V is used, wherein the bias voltage level is set to be asymmetric or symmetric, and wherein the timing ratio t_{neg} :tₚₒₛ of the negative bias voltage to the positive bias voltage is in a range from 10:1 to 1:5,
or
- at least one carbon-containing target is used as a carbon source for producing the TiCN layer, which target is sputtered by means of a HiPIMS process in a coating chamber with the reactive atmosphere having only nitrogen gas as the reactive gas.

2. The method according to claim 1, in which a carbon-containing gas is used as a carbon source, wherein the carbon-containing gas comprises CH₄ or consists of CH₄.

3. The method according to claim 1, in which a carbon-containing gas is used as a carbon source, wherein the carbon-containing gas comprises C₂H₂ or consists of C₂H₂.

4. The method according to claim 1, in which at least one carbon-containing target is used as a carbon source, wherein one or several Ti-containing targets are operated using a first power supply device or a first power supply unit, and one or several carbon-containing targets are operated with pulsed power using a second power supply device or a second power supply unit.

5. The method according to claim 4, wherein at least one Ti-containing target is a metallic target consisting of Ti.

6. The method according to claim 4, wherein at least one Ti-containing target is a ceramic target consisting of TiC.

7. The method according to any one of the preceding claims 4 to 6, in which at least one carbon-containing target consists of graphite.

8. The method according to any one of the preceding claims 4 to 6, in which the at least one carbon-containing target consists of a composite material.

9. The method according to claim 8, wherein the target consists of a composite material comprising at least one metal and one carbide.

## Revendications

1. Procédé de dépôt d'un revêtement avec au moins une couche de TiCN sur une surface d'un substrat à revêtir au moyen d'une procédure HiPIMS, dans lequel, pour le dépôt de ladite au moins une couche de TiCN, au moins une cible contenant du Ti est utilisée comme source de Ti pour la génération de la couche de TiCN, qui est pulvérisée dans une atmosphère réactive au moyen d'une procédure HiPIMS dans une chambre de revêtement, l'atmosphère réactive comprenant au moins un gaz noble et au moins de l'azote gazeux comme gaz réactif,
**caractérisé en ce que**
pour réduire les défauts de croissance lors du dépôt de ladite au moins une couche de TiCN
- l'atmosphère réactive comprend en supplément comme second gaz réactif un gaz contenant du carbone qui est utilisé comme source de carbone pour la génération de la couche de TiCN, et pendant le dépôt de la couche de TiCN une tension de polarisation bipolaire est appliquée au substrat à revêtir, la tension de polarisation étant utilisée dans une plage de -20 V à -200 V, le niveau de tension de polarisation étant ajusté de manière à être asymétrique ou symétrique, et le rapport temporel t_{neg}:tₚₒₛ de la tension de polarisation négative sur la tension de polarisation positive est dans une plage de 10:1 à 1:5,
ou
- comme source de carbone pour la génération de la couche de TiCN, on utilise au moins une cible contenant du carbone, qui est pulvérisée dans la chambre de revêtement avec l'atmosphère réactive avec seulement de l'azote gazeux comme gaz réactif au moyen d'une procédure HiPIMS.

2. Procédé selon la revendication 1,
dans lequel
un gaz contenant du carbone est utilisé comme source de carbone, et le gaz contenant du carbone comprend du CH₄ ou est constitué de CH₄.

3. Procédé selon la revendication 1,
dans lequel
un gaz contenant du carbone est utilisé comme source de carbone, et le gaz contenant du carbone comprend du C₂H₂ ou est constitué de C₂H₂.

4. Procédé selon la revendication 1,
dans lequel
au moins une cible contenant du carbone est utilisée comme source de carbone, une ou plusieurs cibles contenant du Ti sont exploitées par un premier dispositif d'alimentation électrique ou par une première unité d'alimentation électrique, et une ou plusieurs cibles contenant du carbone sont exploitées par un deuxième dispositif d'alimentation électrique ou par une deuxième unité d'alimentation électrique à puissance puisée.

5. Procédé selon la revendication 4,
dans lequel
au moins une cible contenant du Ti est une cible métallique constituée de Ti.

6. Procédé selon la revendication 4,
dans lequel
au moins une cible contenant du Ti est une cible céramique constituée de TiC.

7. Procédé selon l'une des revendications précédentes 4 à 6,
dans lequel
au moins une cible contenant du carbone est constituée de graphite.

8. Procédé selon l'une des revendications précédentes 4 à 6,
dans lequel
ladite au moins une cible contenant du carbone est constituée d'un matériau composite.

9. Procédé selon la revendication 8,
dans lequel
la cible est constituée d'un matériau composite qui comprend au moins un métal et un carbure.
